# EUROPEAN PATENT APPLICATION

(11) **EP 4 693 369 A1**
(43) Date of publication of application: **11.02.2026**
(21) Application number: 24778735.1
(22) Date of filing: 09.02.2024
(51) Int. Cl.: H01L 21/02, H01L 21/20

(54) **METHOD FOR MANUFACTURING SEMICONDUCTOR SUBSTRATE, SEMICONDUCTOR SUBSTRATE, AND SEMICONDUCTOR DEVICE**

(30) Priority: 24.03.2023 JP 2023048530
(71) Applicant: Shin-Etsu Handotai Co., Ltd., Tokyo 100-0004 (JP)
(72) Inventor: OHTSUKI Tsuyoshi, Nishishirakawa-gun, Fukushima 961-8061 (JP); MATSUBARA Toshiki, Nishishirakawa-gun, Fukushima 961-8061 (JP); SUZUKI Atsushi, Nishishirakawa-gun, Fukushima 961-8061 (JP); ABE Tatsuo, Nishishirakawa-gun, Fukushima 961-8061 (JP); SATO Michito, Nishishirakawa-gun, Fukushima 961-8061 (JP)
(74) Representative: Schicker, Silvia
(86) International application number: PCT/JP2024/004569
(87) International publication number: WO 2024/202590

(57) **Abstract**

The present invention is a method for producing a semiconductor substrate, the method including the steps of implanting an ion of at least one of silicon, carbon, or oxygen into a surface of a 4H-SiC substrate, to form, within the 4H-SiC substrate, an amorphous layer composed of amorphized silicon and carbon, bonding the 4H-SiC substrate that is subjected to the step of implanting the ion and another support substrate via a thin film, to obtain a bonded substrate, separating the 4H-SiC substrate at the amorphous layer from the bonded substrate, thereby dividing the bonded substrate into a joined substrate in which a surface layer of the 4H-SiC substrate is transferred on the support substrate, and a separated substrate that is the 4H-SiC substrate after the surface layer has been separated, etching a separation surface of at least one of the joined substrate or the separated substrate, both of which have been subjected to the step of separating, by plasma etching, and performing epitaxial growth on at least one of the joined substrate or the separated substrate. This provides the method for producing a semiconductor substrate, which can produce a less expensive and higher quality semiconductor substrate.

## Description

### TECHNICAL FIELD

The present invention relates to a method for producing a semiconductor substrate, a semiconductor substrate, and a semiconductor device.

### BACKGROUND ART

SiC is expected to be a semiconductor material for a variety of semiconductor devices, such as power devices and high-frequency devices, due to a wide bandgap of 2.2 to 3.3 eV, which provides high dielectric breakdown strength and high thermal conductivity.

However, it has been reported in Non Patent Document 1 that in devices using SiC, a SiC substrate production step and a subsequent epitaxial step account for half of costs, and thus, reducing the costs of the substrates is of significant importance.

For this cost reduction method, a method has been proposed in which H⁺ ions are implanted into a 4H-SiC substrate to perform a substrate separation. Regarding this H⁺ implantation into the SiC, several prior arts have been reported.

Patent Document 1 discloses a method in which two SiC single-crystal wafers are provided, and oxidation layers are formed on each of the wafers. After hydrogen ions are implanted into one of substrates, the bonding and integration are performed at room temperature via the oxidation layers. Subsequently, heat treatment at a temperature of 500°C or higher is performed, thereby splitting the SiC single-crystal wafers along the hydrogen ion-implanted portion to produce a substrate for a semiconductor electric device. According to this method, oxide films are present at the bonded portion; accordingly, the oxide film functions as an insulating layer when configuring a vertical device, thereby significantly limiting functionality of the power device substrate.

Moreover, Patent Document 2 discloses a method to bond a single-crystal SiC substrate, in which H⁺ is implanted, to a polycrystal SiC substrate, and then separate into a single-crystal and a polycrystal, respectively. This method presents difficulty due to a cost increase caused by performing separation twice, and a need to perform the separation at respective predetermined steps.

Patent Document 3 discloses a method for transferring a high-resistance substrate having a low defect density, with a focus on impurity concentration and defect density, by using H⁺ implantation. While this method is a method for reducing defects present in an original substrate, references regarding the substrate after separation are absent.

Furthermore, Patent Document 4 discloses a technique for a base of substrate separation using H⁺ ion implantation, and while the function of a diffusion barrier (oxygen diffusion barrier) is referred to, the substrate after separation is not referred to.

Furthermore, Patent Document 5 also discloses a method for producing a variety of substrates using separation techniques using H⁺. In this method, InGaN is epitaxially grown after polishing or dry etching of the substrate surface. However, no description is provided regarding the handling of the separated substrate.

In addition, Patent Document 6 discloses a method in which including: a device is formed on a silicon carbide substrate; a protective film is formed on the device; ions are then implanted into the substrate; and the substrate is bonded to a support substrate, and then the high-temperature annealing is performed; and the separated substrates are reused. However, no disclosure is also provided regarding handling of the substrates after separation.

Moreover, Patent document 7 discloses a method in which, by applying H⁺ separation, after ion implantation into a single-crystal SiC, a polycrystalline SiC is formed on the opposite side, followed by annealing, a substrate is then separated at the ion-implantation surface, and the SiC is epitaxially grown after polishing the separation surface. As described above, as for substrate techniques using H⁺, no specific method is disclosed regarding the reuse of the separated substrate.

Moreover, as methods for forming a support substrate when implanting H⁺ ions and then separating thereof, Patent Document 8 discloses a growth of polycrystalline SiC on the substrate, in which after H⁺ has been implanted, at a temperature of 1000 to 1600°C. Patent Document 9 discloses growth of a substrate, in which after H⁺ has been implanted, by DLI-CVD (Direct Liquid Injection-CVD). Patent Document 10 discloses methods, such as sintering and liquid-phase deposition, for the substrate after H⁺ has been implanted.

These methods are adopted because, as also disclosed in Patent Document 8, bonding SiC to SiC is difficult, and bonding via W or Mo has been pointed out to involve problems due to the presence of an intervening metal.

However, when deposition is performed on the support substrate at high temperature following the H⁺ implantation in these ways, the separation at the H⁺ implantation layer may occur during the deposition. Moreover, the substrate having the H⁺ implantation layer itself, which is intended for reuse, is exposed to high temperature and subjected to not only a change in crystallinity but also the formation of a polycrystalline layer on the side surface, thereby hindering the reuse.

### CITATION LIST

### PATENT LITERATURE

Patent Document 1: JP H11-003842 A
Patent Document 2: JP 2016-018890 A
Patent Document 3: JP 2014-022711 A
Patent Document 4: JP 2007-329470 A
Patent Document 5: JP 2013-513963 A
Patent Document 6: JP 2022-140396 A
Patent Document 7: WO 2022/158085 A1
Patent Document 8: JP 2022-542224 A
Patent Document 9: JP 2023-502571 A
Patent Document 10: JP 2023-502572 A

### NON PATENT LITERATURE

Non-Patent Document 1: Iwamuro, "Progress in High Performance and High Reliability of SiC MOSFETs," proceedings of the Special Open Symposium of the Japan Society of Wide Gap Semiconductors, 2022, the Japan Society of Wide Gap Semiconductors.
Non-Patent Document 2: H. Biard, W. Schwarzenbach, S. Odoul, I. Radu, A. Potier, M. Ferrato, E. Guajioty, "Tailored polycrystalline substrate for SmartSiCTM substrates enabling high performance power devices", ICSCRM2022, 2022.
Non-Patent Document 3: Suga, "Surface activated bonding at room temperature and its bonding mechanism", Applied Physics, 89(9), p. 498, 2020, the Japan Society of Applied Physics.

### SUMMARY OF INVENTION

### TECHNICAL PROBLEM

As described above, 4H-SiC is expected to be used in high-voltage devices; however, the high cost of the substrates remains a problem, and a way to reduce the cost of bulk substrates remains a challenge. To address this, techniques have been proposed in which H⁺ ions are implanted into the substrate and followed by separation of the substrates. In such cases, cost reduction can be achieved by reusing the separated substrate (otherwise, the cost remains high). Accordingly, how to reuse the separated substrate (how to make it high quality) is of critical importance, and constitutes a core technique for the widespread adoption of a substrate separation technique using H⁺ ions or the like.

On the other hand, the separated substrate after H⁺ ion implantation to separate the substrates has a roughened separation surface, which makes another bonding impossible without planarization, and it is inherently difficult to bond SiC to SiC. Moreover, it is often preferable to planarize the separation surface of the SiC, which is transferred onto the support substrate by the separation, and then perform epitaxial growth, or the like, on the separation surface.

However, SiC is a hard-to-process material with high hardness, which results in high planarization costs through polishing methods, such as CMP, and thus leads to an increase in the eventual substrate production cost. Furthermore, in a method where the support substrate is grown after H⁺ ion implantation, the separation during the growth of the support substrate, or unintended growth of polycrystalline SiC on the original substrate, may hinder the reuse.

In case of the H⁺ implantation, however, when deposition is performed on the support substrate at high temperature following the H⁺ implantation as described earlier, the separation at the H⁺ implantation layer may occur during the deposition. Moreover, the substrate having the H⁺ implantation layer itself, which is intended for reuse, is exposed to high temperature and subjected to not only a change in crystallinity but also the formation of a polycrystalline layer, or the like, on the side surface, thereby hindering the reuse.

The present invention has been made to solve the above-described problem. An object of the present invention is to provide a method for producing a semiconductor substrate, which can produce a less expensive and higher quality semiconductor substrate by using the separation technique for 4H-SiC.

Moreover, another object of the present invention is to provide a less expensive and high-quality semiconductor substrate and semiconductor device.

### SOLUTION TO PROBLEM

The present invention relates to a method for producing a SiC wafer, which is developed to achieve the above object. More specifically, the present invention pertains to a substrate separation technique utilizing an implantation of an ion of silicon, carbon, or oxygen, including bonding to a support substrate and reuse of the substrate after separation, thereby providing a less expensive and high-quality SiC substrate. Specifically, the present invention has been made to achieve the above objects and provides a method for producing a semiconductor substrate, the method comprising the steps of:
implanting an ion of at least one of silicon, carbon, or oxygen into a surface of a 4H-SiC substrate, to form, within the 4H-SiC substrate, an amorphous layer composed of amorphized silicon and carbon;
bonding the surface of the 4H-SiC substrate and a bonding surface of another support substrate via a thin film formed on at least one of the surface of the 4H-SiC substrate that is subjected to the step of implanting the ion or the bonding surface of the support substrate, to obtain a bonded substrate;
separating the 4H-SiC substrate at the amorphous layer from the bonded substrate, thereby dividing the bonded substrate into a joined substrate in which a surface layer of the 4H-SiC substrate is transferred as a 4H-SiC layer on the support substrate, and a separated substrate that is the 4H-SiC substrate after the surface layer has been separated;
etching a separation surface of at least one of the joined substrate or the separated substrate, both of which have been subjected to the step of separating, by plasma etching; and
performing epitaxial growth on at least one of the joined substrate or the separated substrate.

According to such a method for producing a semiconductor substrate, the ion of at least one of silicon, carbon, or oxygen is implanted in the surface of the 4H-SiC substrate. This implantation breaks a bond between the silicon and the carbon to form the amorphous layer, and then bonds the 4H-SiC substrate to the support substrate. Subsequently, the 4H-SiC substrate is separated at the amorphous layer, thereby transferring the 4H-SiC layer onto the joined substrate.

In this way, during the step of implanting the ion by utilizing the ion implantation with at least one of silicon, carbon, or oxygen, it is possible to introduce damage at a predetermined depth by adjusting an acceleration energy during implantation. The damage specifically refers to breaking the bond between the silicon and the carbon by ion-implanting with the ion. The silicon and the carbon, being broken, are present in an amorphous state, respectively.

The amorphous layer thus formed is separated by inserting a thin metal-like object laterally and applying an impact. Furthermore, the amorphous layer absorbs more light as blackened due to an influence of carbon; consequently, it is possible to separate at the amorphous layer by irradiating this portion with light to further excite. Alternatively, it is also possible to separate by a combination of both irradiating the amorphous layer with light and applying the impact thereto.

In particular, when silicon or carbon is ion-implanted, such a separated layer is not separated even when a somewhat high temperature is applied, enabling the step of separating at a predetermined point in the production steps. In addition, when oxygen is ion-implanted, the separation can be performed by applying heat treatment to bond the implanted oxygen to the carbon in the amorphous layer and gasify thereof.

In this way, in the present invention, the ion at least one of silicon, carbon, or oxygen is implanted and bonding is then performed; at this time, while a single crystal is typically used for the support substrate, the use of a polycrystalline body and a sintered body for the support substrate enables significant cost reduction.

Moreover, it has been reported (Non-Patent Document 2) that the use of the polycrystalline body can achieve a greater reduction in substrate resistance, and thus, is more effective. When considering application in vertical devices, in addition to a cost advantage, it is highly effective for improving quality.

Further, by sputtering a thin film, such as silicon, to the bonding surface between the substrate, which has been implanted with the ion, such as silicon, and the support substrate, and by bonding each other via this thin film, it becomes possible to bond SiC substrates to each other, which are difficult to bond.

In particular, by providing an inexpensive support substrate, such as the polycrystalline body, and forming a thin film, such as silicon, on the bonding surface to bond therebetween via the film, such as silicon, this enables bonding between SiC even when the support substrate is composed of SiC, which has been difficult to bond.

Furthermore, in the present invention, at least one of the separated substrate or the joined substrate is subjected to plasma etching on the separation surface to remove the damaged layer and thus planarize the surface, after which the substrate is reused or epitaxially grown. This enables planarization of SiC, which is a hard-to-process material, at a lower cost compared to polishing, such as CMP, and thus, a high-quality substrate can be obtained.

Note that normally, SiC is not easily plasma etched; the etching thereof can be performed due to a weakening effect of the surface caused by the ion implantation. When a single high-quality SiC substrate can be provided by performing epitaxial growth using a CVD method in this way, it becomes possible to repeatedly and inexpensively produce a high-quality SiC substrate by repeating the ion implanting step, bonding step, separation step, etching step, and performing epitaxial growth step, thereby transferring the surface layer of the 4H-SiC substrate onto the support substrate and performing epitaxial growth using the CVD method.

In this case, it is possible that in the step of separating, the 4H-SiC substrate is separated by irradiating the amorphous layer with light, applying impact thereto, or performing combined processes thereof.

In this way, by irradiating the amorphous layer with light and causing it to absorb the light, energy required for the separation can be directly imparted to the amorphous layer.

Moreover, when the bonded substrate is separated by applying the impact to the amorphous layer, the separation can be achieved simply by inserting, for example, a thin metal blade-like object into the amorphous layer, which is advantageous in that the facility required for separation can be simplified.

Moreover, by combining the light irradiation and the impact to perform separation, the time required for separation can be shortened compared to the case where each is applied individually.

In this case, it is possible that in the step of implanting the ion, the oxygen ion is implanted, and
in the step of separating, the 4H-SiC substrate is separated by irradiating the amorphous layer with light, applying impact thereto, performing heat treatment to generate a gas through a reaction between the implanted oxygen and carbon in the amorphous layer, or performing combined processes thereof.

In this way, by irradiating the amorphous layer with light, energy required for the separation can be directly imparted to the amorphous layer. Moreover, when the bonded substrate is separated by applying the impact to the amorphous layer, the separation can be achieved simply by inserting, for example, a thin metal blade-like object into the amorphous layer.

In addition, when the oxygen ion is implanted in the step of implanting the ion, the implanted oxygen can react with carbon in the amorphous layer to generate the gas, and the resulting gas pressure can be utilized to perform the separation. Accordingly, the separation can be achieved by heating in addition to the light irradiation and the impact, thereby broadening the range of selectable separation methods.

Moreover, by combining these separation methods to separate, the time required for the separation can be shortened compared to performing these methods individually.

In this case, it is possible that in the step of bonding, a silicon thin film is formed as the thin film, and bonding is performed via the silicon thin film.

The silicon thin film is sometimes employed as an underlayer for the epitaxial growth of 4H-SiC, which enables easy bonding with 4H-SiC. In addition, it also allows for easy bonding with the polycrystalline body or the sintered body of SiC. Therefore, by providing the support substrate that is less expensive than single-crystal SiC, such as polycrystalline SiC, and forming a thin silicon on the bonding surface to achieve bonding via the silicon, the bonding can be facilitated.

In this case, it is possible that in the step of bonding, the silicon thin film is formed by a sputtering method using silicon as a target.

In this way, when the silicon thin film is formed by sputtering, in which an inert gas, such as Ar, is ionized and irradiated using silicon as the target for forming, this results in advantages in terms of adhesion and other properties. Note that it has been found that, in this case, the roughness of the bonding surface is preferably 1 nm or less (Non-Patent Document 3).

Moreover, the use of the sputtering method eliminates the need for high-temperature processing of the substrate on which the film is to be formed, and does not roughen the SiC surface of the bonding surface.

In this case, it is possible that in the step of etching, a mixed gas of a fluorocarbon gas and oxygen is used as a raw material gas.

The mixed gas of the fluorocarbon gas and the oxygen is a gas used for etching of e.g., silicon. Consequently, when used as the raw material gas, it is advantageous in that the need to provide a gas dedicated for etching of SiC is eliminated.

At this time, it is possible that after the step of separating and before the step of etching, a step of annealing is performed in which the separation surface of the joined substrate or the separated substrate, which is to be subjected to the step of etching, is annealed at a temperature of 1000°C or higher in a hydrogen atmosphere.

In this way, when hydrogen annealing is performed and the etching is then performed, an uneven shape of the separation surface roughened by separation is modified by hydrogen annealing before etching, resulting in planarization to a certain extent. Accordingly, in the etching step, it is facilitated to further improve the planarity of the separation surface.

At this time, it is possible that in the step of etching, the separation surface of the joined substrate is plasma-etched, and after the step of etching, the step of performing epitaxial growth is performed on the separation surface etched of the joined substrate.

In this way, when an epitaxial layer is grown on the separation surface etched of the joined substrate, the device can be of higher quality by forming the device on the epitaxial layer.

Moreover, the present invention provides a semiconductor substrate comprising:
a support substrate; and
a 4H-SiC layer bonded onto a surface of the support substrate, wherein
the support substrate is composed of SiC, and
the 4H-SiC layer is bonded to the support substrate via a silicon thin film, and has a surface that is subjected to etching treatment.

With such a semiconductor substrate, the surface of the 4H-SiC layer of the semiconductor substrate is subjected to etching treatment, and thus the surface is planarized; as a result, the epitaxial layer can be formed without performing a high-cost planarization treatment, such as CMP, resulting in a less expensive and higher quality semiconductor substrate.

Further, when the 4H-SiC layer is bonded to the support substrate composed of SiC via the silicon thin film, the silicon thin film may also serve as the underlayer for epitaxial growth of the 4H-SiC, thereby enhancing the bonding between the 4H-SiC and the support substrate. Even when the polycrystalline body or the sintered body of SiC is used for the support substrate, the bonding therebetween can be enhanced. Consequently, the bonding between the support substrate and the 4H-SiC layer is enhanced.

Furthermore, the present invention provides a semiconductor device comprising the semiconductor substrate described above.

Such a semiconductor device is provided with a less expensive and higher quality semiconductor substrate described above, resulting in a less expensive and higher quality device with higher reliability.

### ADVANTAGEOUS EFFECTS OF INVENTION

As described above, according to the inventive method for producing a semiconductor substrate, the less expensive and higher quality semiconductor substrate can be produced by employing the 4H-SiC separation technique; as a result, the production cost of the substrate can be reduced. Moreover, according to the inventive method for producing a semiconductor substrate, the 4H-SiC substrate after the separation of the surface layer can be effectively utilized, and the production cost of the semiconductor substrate can be reduced.

Furthermore, the inventive semiconductor substrate can be made less expensive and higher in quality. Similarly, the inventive semiconductor device can be made less expensive and higher in quality.

### BRIEF DESCRIPTION OF DRAWINGS

[FIG. 1] is a schematic view illustrating a semiconductor substrate according to the present invention.
[FIG. 2] is a flow diagram illustrating a method for producing a semiconductor substrate according to the present invention.

### DESCRIPTION OF EMBODIMENTS

Hereinafter, the present invention will be described in detail. However, the present invention is not limited thereto.

As described above, by employing a 4H-SiC separation technique, the following has been desired: a production method capable of producing a less expensive and higher quality semiconductor substrate and reducing the production cost of the substrate; a less expensive and higher quality semiconductor substrate; and a less expensive and higher quality semiconductor device.

To solve the above problem, the present inventors have earnestly studied, and found out that, by employing a method for producing a semiconductor substrate, the method comprising the steps of: implanting an ion of at least one of silicon, carbon, or oxygen into a surface of a 4H-SiC substrate, to form, within the 4H-SiC substrate, an amorphous layer composed of amorphized silicon and carbon; bonding the surface of the 4H-SiC substrate and a bonding surface of another support substrate via a thin film formed on at least one of the surface of the 4H-SiC substrate that is subjected to the step of implanting the ion or the bonding surface of the support substrate, to obtain a bonded substrate; separating the 4H-SiC substrate at the amorphous layer from the bonded substrate, thereby dividing the bonded substrate into a joined substrate in which a surface layer of the 4H-SiC substrate is transferred as a 4H-SiC layer on the support substrate, and a separated substrate that is the 4H-SiC substrate after the surface layer has been separated; etching a separation surface of at least one of the joined substrate or the separated substrate, both of which have been subjected to the step of separating, by plasma etching; and performing epitaxial growth on at least one of the joined substrate or the separated substrate, a less expensive and higher quality semiconductor substrate can be produced by using a 4H-SiC separation technique. Thus, the present invention has been completed.

Moreover, the present inventors have earnestly studied to solve the above problem, and found out that, by employing a semiconductor substrate comprising: a support substrate; and a 4H-SiC layer bonded onto a surface of the support substrate, wherein the support substrate is composed of SiC, and the 4H-SiC layer is bonded to the support substrate via a silicon thin film, and has a surface that is subjected to etching treatment, a less expensive and higher quality semiconductor substrate can be provided. Thus, the present invention has been completed.

Further, the present inventors have earnestly studied to solve the above problem, and found out that, by employing a semiconductor device comprising the semiconductor substrate described above, a less expensive and higher quality semiconductor device can be provided. Thus, the present invention has been completed.

Hereinafter, a suitable embodiment for the present invention will be described with reference to the drawings.

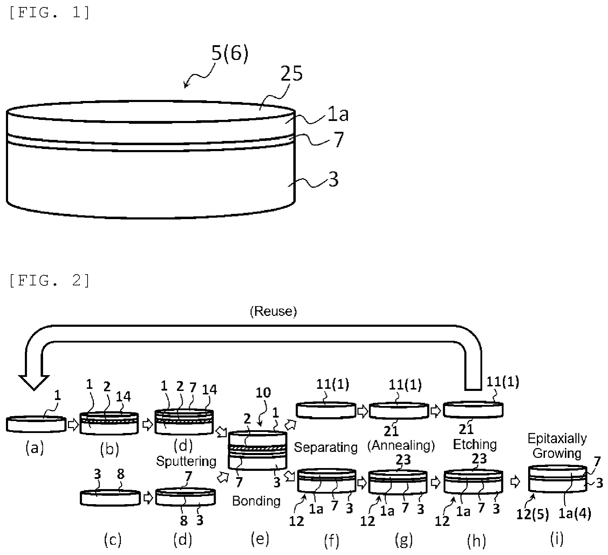

To begin with, a configuration of a semiconductor substrate 5 is described with reference to FIG. 1.

As shown in FIG. 1, the semiconductor substrate 5 according to the embodiment of the present invention is provided with a support substrate 3, a 4H-SiC layer 1a bonded onto a surface of the support substrate 3, in which the 4H-SiC layer 1a is bonded to the support substrate 3 via a thin film 7.

The support substrate 3 is a substrate to support the 4H-SiC layer 1a via the thin film 7, and as long as the substrate has sufficient strength to support the 4H-SiC layer 1a and does not cause an unintended reaction with the thin film 7, materials and dimensions thereof can be selected as appropriate. Specifically, a bulk 4H-SiC that uses the same material as the 4H-SiC layer 1a can be exemplified; however, taking price into consideration, the SiC substrate produced by sintering or a polycrystalline SiC substrate, which is less expensive than the bulk 4H-SiC, may be used.

The 4H-SiC layer 1a is a single-crystal layer of 4H-SiC and is bonded to the surface of the support substrate 3. For this bonding, the thin film 7 is formed on the bonding surface between the 4H-SiC layer 1a and the support substrate 3. By bonding via this thin film 7, a strong bonding can be achieved.

The thin film 7 is a material capable of bonding to both the 4H-SiC layer 1a and the support substrate 3, and may be, for example, a silicon thin film. In the following description, unless otherwise specified, the present invention will be described using, as an example, a case in which the silicon thin film is used as the thin film 7.

Moreover, the 4H-SiC layer 1a has a surface 25 that has been subjected to an etching treatment. As the 4H-SiC layer 1a has the surface 25 that has been subjected to an etching treatment, the surface 25 becomes planar, allowing the epitaxial layer to be formed without a high-cost planarization treatment, such as CMP. Accordingly, a less expensive and higher quality semiconductor substrate 5 can be obtained.

The 4H-SiC layer 1a may be either the bulk 4H-SiC or a 4H-SiC epitaxial layer, as long as it is a single-crystal layer.

The thickness of the 4H-SiC layer 1a may be set to a minimum thickness sufficient to maintain the form of the layer, allow device formation, and prevent removal thereof by etching, polishing, or the like during the processes. In contrast, the maximum thickness is, for example, a thickness such that an unnecessary portion not used in device formation is minimized. The film thickness can be, for example, 0.01 µm to 400 µm.

Next, a configuration of a semiconductor device 6 is described with reference to FIG. 1.

The semiconductor device 6, shown in FIG. 1, is provided with the semiconductor substrate 5.

As the specific semiconductor device 6, the semiconductor substrate 5, in particular, in which a desired semiconductor device is formed on the 4H-SiC layer 1a, can be exemplified. Naturally, the semiconductor device 6 can also be diced into individual chips.

By providing the semiconductor device 6 with the less expensive and higher quality semiconductor substrate 5, the semiconductor device 6 also becomes less expensive, higher quality, and highly reliable.

Next, with reference to FIG. 2, an overview of the inventive method for producing a semiconductor substrate 5 will be described.

First, as shown in FIG. 2(a), a 4H-SiC substrate 1 is provided. Here, a bulk single-crystal 4H-SiC is exemplified as the 4H-SiC substrate 1; however, a 4H-SiC epitaxial substrate may also be used.

In this embodiment, the surface layer of the 4H-SiC substrate 1 is transferred to the support substrate 3, but a separated substrate 11, which remained after the transfer in the end, may be reused as the 4H-SiC substrate 1. These 4H-SiC substrates 1 are desirably formed by epitaxial growth using CVD.

Subsequently, the ion of at least one of silicon, carbon, or oxygen is implanted into the 4H-SiC substrate 1 to break the bond between the silicon and the carbon near a surface of the 4H-SiC substrate 1, thereby forming an amorphous layer 2 in which each of the silicon and the carbon is present in an amorphous state, as shown in FIG. 2(b) (Step of implanting an ion).

At this time, by adjusting an acceleration energy during the ion implantation, the amorphous layer 2 can be formed at a predetermined depth, in which each of the silicon and the carbon is present in the amorphous state. Note that when oxygen is ion-implanted, a layer in which the amorphous layer 2 and oxygen are present is formed.

An ionic species to be implanted may be at least one of silicon, carbon, or oxygen, and a plurality of ion species may be implanted. Moreover, among the silicon, carbon, and oxygen, the ion to be implanted may be selected appropriately, considering the respective advantages of each species.

For example, when the silicon or carbon is ion-implanted, these elements are elements that constitute SiC, and thus are advantageous in that the implanting thereof does not result in impurities. On the other hand, when oxygen is ion-implanted, the 4H-SiC substrate 1 can be separated by heating in the subsequent step, which is advantageous in that a wide range of selectable separating methods is provided.

Moreover, the acceleration energy during the ion implantation varies depending on a position in a depth direction at which the amorphous layer 2 is formed. Specifically, the deeper the position in the depth direction, the greater the acceleration energy; for example, approximately 200 keV.

An amount of implanted ions may be an extent sufficient to be capable of forming the amorphous layer 2, and for example, is approximately 1.0×10¹⁷ atoms/cm².

Next, as shown in FIG. 2(c), a substrate different from the 4H-SiC substrate 1 is provided as the support substrate 3. Although the support substrate 3 may be a single-crystal 4H-SiC having the same structure as the 4H-SiC substrate 1, when the cost is considered, it is preferable to use a sintered SiC produced by sintering thereof, polycrystalline SiC, or the like.

Next, as shown in FIG. 2(d), after the thin film 7, such as the silicon thin film, is formed on a bonding surface 8 of the support substrate 3 and a surface 14 of the 4H-SiC substrate 1 which is subjected to the step of implanting the ion, such as silicon, these surfaces are bonded together to obtain a bonded substrate 10 shown in FIG. 2(e) (Step of bonding).

As for the thin film 7, it is preferable to form the silicon thin film and perform bonding via this film.

The silicon thin film may be used as an underlayer for epitaxial growth of 4H-SiC at times; thus, this film is easily bonded to 4H-SiC, and also is readily bonded to the polycrystalline body or the sintered body of SiC. Accordingly, by providing the support substrate 3 made of the polycrystalline SiC, or the like, which is less expensive than the single crystal SiC, forming thin silicon on the bonding surface 8, and performing bonding via the silicon, it becomes possible to bond even SiC that is difficult to bond.

Regarding a specific method for forming the thin film 7, a sputtering method in which Ar ion is irradiated onto a target, being silicon as the target, to form the film is effective because high-temperature heating to the substrate is not required, and the SiC surface of the bonding surface is not roughened.

Moreover, as a method for bonding the 4H-SiC substrate 1 and the support substrate 3 via the thin film 7, for example, a room-temperature bonding can be exemplified.

Next, as shown in FIG. 2(f), by separating the 4H-SiC substrate 1 at the amorphous layer 2 of the bonded substrate 10, the bonded substrate 10 is divided into a joined substrate 12 in which the surface layer of the 4H-SiC substrate 1 is transferred as the 4H-SiC layer 1a on the support substrate 3, and the separated substrate 11 that is the 4H-SiC substrate 1 after the surface layer has been separated (Step of separating).

Specifically, in the step of separating, the 4H-SiC substrate 1 can be separated by performing light irradiation, impact application, or a combined treatment thereof to the amorphous layer 2.

When performing the light irradiation, the bonded substrate 10 is irradiated with the light, and the light is absorbed at the amorphous layer 2, which includes the silicon and the carbon, formed in the step of implanting an ion. With this absorbing portion as a starting point, the 4H-SiC substrate 1 is separated, and thus, the bonded substrate 10 is divided into the joined substrate 12 in which the surface layer of the 4H-SiC substrate 1 is transferred as the 4H-SiC layer 1a on the support substrate 3, and the separated substrate 11 that is the 4H-SiC substrate 1 after the surface layer has been separated.

In this way, by irradiating the amorphous layer 2 with the light and making that layer absorb the light, energy required for separation can be directly imparted to the amorphous layer 2.

A light source for light irradiated is not particularly limited as long as energy is imparted to the amorphous layer 2 in the amount sufficient to separate the 4H-SiC substrate 1 from the amorphous layer 2 as the starting point, but a YAG laser can be exemplified. When the YAG laser is used as the light source, the fundamental wavelength (1064 nm) can be exemplified as the wavelength of the light to be irradiated.

In the step of separating, when applying the impact to the amorphous layer 2, the separation can be achieved simply by inserting, for example, a thin metal blade-like object into the amorphous layer 2 without irradiating the light.

In this way, a method for applying the impact to the amorphous layer 2 to separate is advantageous in that the facility required for separation can be simplified.

Furthermore, the separation can also be achieved by combining the light irradiation with the impact. Specifically, in addition to irradiating the light, separation may be achieved, for example, by inserting a thin metal blade-like object into the amorphous layer 2 of carbon and applying the impact thereto. In this case, compared to performing light irradiation or impact application alone, the time required for separation can be shortened.

When the oxygen ion is implanted in the step of implanting the ion, the 4H-SiC substrate 1 can be separated in the step of separating by irradiating the amorphous layer 2 with light, applying impact thereto, performing heat treatment to generate a gas through a reaction between the implanted oxygen and the carbon in the amorphous layer, or performing combined processes thereof.

A separation surface 23 of the joined substrate 12 obtained through the above separation has a roughened surface; therefore, it may be preferable to planarize the surface in some cases when the epitaxial layer is desired to be formed in a later step. In addition, the separated substrate 11 can be reused by further repeating the step of implanting the ion, the step of bonding, and the step of separating, thereby allowing the surface layers to be transferred to a plurality of the support substrates 3. However, the separation surface 21 has a surface roughened; it is required to planarize the surface to bond to the support substrate 3. Consequently, a procedure for planarizing the separation surfaces 23 and 21 is described below.

To begin with, as shown in FIG. 2(h), at least one of the separation surface 23 of the joined substrate 12 or the separation surface 21 of the separated substrate 11 after the step of separating is etched by plasma etching (Step of etching).

Note that, in FIG. 2, although a case where both the separation surface 23 of the joined substrate 12 and the separation surface 21 of the separated substrate 11 are etched is exemplified, at least one of those may be etched. For example, in a case where the epitaxial layer can be formed without planarizing the separation surface 23 of the joined substrate 12, or in a case where the 4H-SiC layer 1a is the epitaxial layer and it is not required to further form the epitaxial layer, only the separation surface 21 of the separated substrate 11 may be etched.

By subjecting at least one of the separation surface 23 of the joined substrate 12 or the separation surface 21 of the separated substrate 11 to plasma etching, a surface of SiC, which is a hard-to-process material, can be planarized inexpensively compared to CMP, etc.

A mixed gas of a fluorocarbon gas and oxygen can be used as a raw material gas for etching. The specific fluorocarbon gas is preferably CHF₃ or CF₄. The mixed gas of the fluorocarbon gas and the oxygen is the gas used for etching the silicon and the like; consequently, using this gas as the raw material gas eliminates the need to provide the gas specifically for SiC etching, which is advantageous.

Moreover, a plasma form in the step of etching is not particularly limited as long as it is optimized by an apparatus, but RF plasma can be exemplified. Note that in general, SiC is not etched using such a mix gas of the fluorocarbon gas and the oxygen gas. However, by performing the step of implanting the ion, the separation surfaces 23 and 21 are weakened, and as the surface layers thereof are damaged layers, these layers, including the separation surfaces 23 and 21, can be removed through etching, resulting in planarization. Furthermore, the weakening can be achieved not only by causing damage from the ion implantation but also by subjecting to a plasma treatment using H₂ gas.

Note that after the step of separating and before the step of etching, as shown in FIG. 2(g), the separation surface 23 of the joined substrate 12 or the separation surface 21 of the separated substrate 11, which is to be subjected to the step of etching, may be annealed at a temperature of 1000°C or higher in a hydrogen atmosphere (Step of annealing). The upper limit of the annealing temperature is not particularly limited, but can be 2000°C or lower.

By performing a hydrogen annealing in the step of annealing and then performing the step of etching in this way, the uneven shape of the separation surface 23 or the separation surface 21, which has been roughened due to separation, is modified through the hydrogen annealing before etching and partially planarized. As a result, the planarity of the separation surface 23 or the separation surface 21 can be more readily improved in the step of etching.

The separated substrate 11, after the step of separation, can be reused as the 4H-SiC substrate 1 for transferring the 4H-SiC onto the support substrate 3 by further repeating the steps of implanting the ion, the step of bonding, and the step of separating until the thickness becomes too thin to allow further separation.

Here, when the separation surface 21 of the separated substrate 11 has been etched in the step of etching, the separation surface 21 is planarized by the etching, and thus, the support substrate 3 can be bonded to the separation surface 21 without performing a high-cost planarization treatment, such as CMP.

Next, the epitaxial growth is performed on at least one of the joined substrate 12 or the separated substrate 11 (Step of performing epitaxial growth). Specifically, an epitaxial layer 4 may be grown using CVD, etc.

In FIG. 2(i), a case is exemplified in which the epitaxial layer 4 of 4H-SiC is grown on the 4H-SiC layer 1a of the joined substrate 12.

Here, when the separation surface 23 of the 4H-SiC layer 1a is etched in the step of etching, the separation surface 23 is planarized by etching. Consequently, the epitaxial layer 4 can be formed on the separation surface 23 without performing the high-cost planarization treatment, such as CMP. This enables the joined substrate 12 to serve as the less expensive and higher quality semiconductor substrate 5.

Note that, when the 4H-SiC layer 1a is the epitaxial layer and the thickness of the transferred 4H-SiC layer 1a is a thickness sufficient for forming the device in the subsequent step, it is not necessarily required to perform the step of performing epitaxial growth shown in FIG. 2(i).

On the other hand, when the 4H-SiC layer 1a is not the epitaxial layer, or the 4H-SiC layer 1a is the epitaxial layer but the film thickness is not sufficient to form the device when transferred in the step of separating, it is preferable to perform the step of performing epitaxial growth on the joined substrate 12. In this case, it is preferable to smooth the separation surface 23 in the step of etching before conducting the step of performing epitaxial growth on the joined substrate 12.

Specifically, as shown in FIG. 2(h), it is preferable to perform the plasma etching on the separation surface 23 of the joined substrate 12 in the step of etching. In addition, on the separation surface 23 etched of the joined substrate 12, in the step of performing epitaxial growth as shown in FIG. 2(i), it is preferable to grow the epitaxial layer 4 on the separation surface 23 etched of the joined substrate 12.

By growing the epitaxial layer 4 on the separation surface 23 etched of the joined substrate 12 in this way, it is possible to make the device higher quality by forming the device on the epitaxial layer 4.

### EXAMPLES

Hereinafter, the present invention will be specifically described with reference to Examples. However, the present invention is not limited thereto.

After a 4H-SiC substrate 1 was subjected to a step of implanting an ion of silicon, carbon, or oxygen, a step of bonding (a formation of a silicon thin film and bonding), a step of separating, and a step of etching, and further subjected to the step of implanting the ion and the step of bonding, a separated substrate 11 was attempted to be reused as the 4H-SiC substrate 1.

### (Example 1)

First, as a 4H-SiC substrate 1, a 4H-SiC single crystal substrate having a diameter of 200 mm, a thickness of 355 µm, n-type, a resistivity of 10 Ω·cm, and a 4° off-angle with respect to a (0001) plane was provided. Then, as a step of implanting an ion, a silicon ion was implanted in the substrate at 1×10¹⁷ atoms/cm² using an ion implantation apparatus at an acceleration energy of 200 keV.

Next, a following step was performed as a step of bonding. First, as a support substrate 3, a polycrystalline SiC substrate having a same diameter as the 4H-SiC substrate 1 was provided, and an Ar ion was irradiated to silicon as a target, and silicon thin films as thin films 7 were formed by sputtering on both the 4H-SiC substrate 1 and the support substrate 3. At this time, a thickness of the silicon thin film was set to 20 nm. Subsequently, the 4H-SiC substrate 1 was bonded to the support substrate 3 via the silicon thin films by room temperature bonding to obtain a bonded substrate 10.

Following the step of bonding, as a step of separating, a YAG laser (wavelength 1064 nm) was used to irradiate an amorphous layer 2 with light to excite thereof, thereby separating the bonded substrate 10 into a joined substrate 12 and a separated substrate 11.

As a step of performing epitaxial growth, 4H-SiC was epitaxially grown on this joined substrate 12 using a Hot-wall type CVD apparatus, with H₂ as a carrier gas, SiH₄ and C₃H₈ as raw material gases to obtain a semiconductor substrate 5. A temperature at this time was 1600°C, and a pressure in a furnace was set to 7 kPa.

In this way, as a step of etching, a separation surface 21 of the separated substrate 11, which was produced when the semiconductor substrate 5 was obtained, was subjected to RF plasma etching treatment under the following conditions: raw material gases of CHF₃ and O₂ at 100 sccm and 10 sccm, respectively; a pressure of 100 Torr (13332.2 Pa); and a RF power of 500 W.

When the separated substrate 11, after the step of etching, was further subjected to the step of implanting the silicon ion and the step of bonding in the previous flow once again, the support substrate 3 was successfully bonded to the separation surface 21 of the separated substrate 11, and the bonded substrate 10 was also successfully obtained.

### (Example 2)

First, as a 4H-SiC substrate 1, a 4H-SiC single crystal substrate having a diameter of 200 mm, a thickness of 355 µm, n-type, a resistivity of 10 Ω·cm, and a 4° off-angle with respect to a (0001) plane was provided. Then, as a step of implanting an ion, a carbon ion was implanted in the substrate at 1.0×10¹⁷ atoms/cm² using an ion implantation apparatus at an acceleration energy of 200 keV.

Next, a following step was performed as a step of bonding. First, as a support substrate 3, a polycrystalline SiC substrate having a same diameter as the 4H-SiC substrate 1 was provided, and an Ar ion was irradiated to silicon as a target, and the silicon as a thin film 7 was formed by sputtering on both the 4H-SiC substrate 1 and the support substrate 3. At this time, a thickness of the silicon thin film was set to 20 nm. Subsequently, the 4H-SiC substrate 1 was bonded to the support substrate 3 via the silicon thin films by room temperature bonding to obtain a bonded substrate 10.

Following the step of bonding, as a step of separating, a YAG laser (wavelength 1064 nm) was used to irradiate an amorphous layer 2 with light to excite thereof, thereby separating the bonded substrate 10 into a joined substrate 12 and a separated substrate 11.

As a step of performing epitaxial growth, 4H-SiC was epitaxially grown on this joined substrate 12 using a Hot-wall type CVD apparatus, with H₂ as a carrier gas, SiH₄ and C₃H₈ as raw material gases to obtain a semiconductor substrate 5. A temperature at this time was 1600°C, and a pressure in a furnace was set to 7 kPa.

In this way, as a step of etching, a separation surface 21 of the separated substrate 11, which was produced when the semiconductor substrate 5 was obtained, was subjected to RF plasma etching treatment under the following conditions: raw material gases of CHF₃ and O₂ at 100 sccm and 10 sccm, respectively; a pressure of 100 Torr (13332.2 Pa); and a RF power of 500 W.

When the separated substrate 11, after the step of etching, was subjected to the step of implanting the carbon ion and the step of bonding in the previous flow for reuse once again, the support substrate 3 was successfully bonded to the separation surface 21 of the separated substrate 11, and the bonded substrate 10 was also successfully obtained.

### (Example 3)

First, as a 4H-SiC substrate 1, a 4H-SiC single crystal substrate having a diameter of 200 mm, a thickness of 355 µm, n-type, a resistivity of 10 Ω·cm, and a 4° off-angle with respect to a (0001) plane was provided. Then, as a step of implanting an ion, an oxygen ion was implanted in the substrate at 1.0×10¹⁷ atoms/cm² using an ion implantation apparatus at an acceleration energy of 200 keV.

Next, a following step was performed as a step of bonding. First, as a support substrate 3, a polycrystalline SiC substrate having a same diameter as the 4H-SiC substrate 1 was provided, and an Ar ion was irradiated to silicon as a target, and the silicon as a thin film 7 was formed by sputtering on both the 4H-SiC substrate 1 and the support substrate 3. At this time, a thickness of the silicon thin film was set to 20 nm. Subsequently, as the step of bonding, the 4H-SiC substrate 1 was bonded to the support substrate 3 by room temperature bonding to obtain a bonded substrate 10.

Following the step of bonding, as a step of separating, a YAG laser (wavelength 1064 nm) was used to irradiate an amorphous layer 2 with light to excite thereof, thereby separating the bonded substrate 10 into a joined substrate 12 and a separated substrate 11.

As a step of performing epitaxial growth, 4H-SiC was epitaxially grown on this joined substrate 12 using a Hot-wall type CVD apparatus, with H₂ as a carrier gas, SiH₄ and C₃H₈ as raw material gases to obtain a semiconductor substrate 5. A temperature at this time was 1600°C, and a pressure in a furnace was set to 7 kPa.

In this way, as a step of etching, a separation surface 21 of the separated substrate 11, which was produced when the semiconductor substrate 5 was obtained, was subjected to RF plasma etching treatment under the following conditions: raw material gases of CHF₃ and O₂ at 100 sccm and 10 sccm, respectively; a pressure of 100 Torr (13332.2 Pa); and a RF power of 500 W.

When the separated substrate 11, after the step of etching, was further subjected to the step of implanting the oxygen ion and the step of bonding in the previous flow once again, the support substrate 3 was successfully bonded to the separation surface 21 of the separated substrate 11, and the bonded substrate 10 was also successfully obtained in the same way.

As described above, according to Examples of the present invention, by implanting the ion into the 4H-SiC substrate 1 to form the amorphous layer 2, and then bonding the support substrate 3 thereto via the thin film 7, and separating the 4H-SiC substrate 1 at the amorphous layer 2, the joined substrate 12 was successfully obtained in which a surface layer of the 4H-SiC substrate 1 was transferred on the support substrate 3 as the 4H-SiC layer 1a. Moreover, the separated substrate 11 was successfully reused as the 4H-SiC substrate 1.

The present description includes the following embodiments.
[1]: A method for producing a semiconductor substrate, the method comprising the steps of:
   implanting an ion of at least one of silicon, carbon, or oxygen into a surface of a 4H-SiC substrate, to form, within the 4H-SiC substrate, an amorphous layer composed of amorphized silicon and carbon;
   bonding the surface of the 4H-SiC substrate and a bonding surface of another support substrate via a thin film formed on at least one of the surface of the 4H-SiC substrate that is subjected to the step of implanting the ion or the bonding surface of the support substrate, to obtain a bonded substrate;
   separating the 4H-SiC substrate at the amorphous layer from the bonded substrate, thereby dividing the bonded substrate into a joined substrate in which a surface layer of the 4H-SiC substrate is transferred as a 4H-SiC layer on the support substrate, and a separated substrate that is the 4H-SiC substrate after the surface layer has been separated;
   etching a separation surface of at least one of the joined substrate or the separated substrate, both of which have been subjected to the step of separating, by plasma etching; and
   performing epitaxial growth on at least one of the joined substrate or the separated substrate.
[2]: The method for producing a semiconductor substrate according to the above [1], wherein
   in the step of separating, the 4H-SiC substrate is separated by irradiating the amorphous layer with light, applying impact thereto, or performing combined processes thereof.
[3]: The method for producing a semiconductor substrate according to the above [1] or [2], wherein
   in the step of implanting the ion, the oxygen ion is implanted, and
   in the step of separating, the 4H-SiC substrate is separated by irradiating the amorphous layer with light, applying impact thereto, performing heat treatment to generate a gas through a reaction between the implanted oxygen and carbon in the amorphous layer, or performing combined processes thereof.
[4]: The method for producing a semiconductor substrate according to any of the above [1] to [3], wherein
   in the step of bonding, a silicon thin film is formed as the thin film, and bonding is performed via the silicon thin film.
[5]: The method for producing a semiconductor substrate according to the above [4], wherein
   in the step of bonding, the silicon thin film is formed by a sputtering method using silicon as a target.
[6]: The method for producing a semiconductor substrate according to any of the above [1] to [5], wherein
   in the step of etching, a mixed gas of a fluorocarbon gas and oxygen is used as a raw material gas.
[7]: The method for producing a semiconductor substrate according to any of the above [1] to [6], wherein
   after the step of separating and before the step of etching, a step of annealing is performed in which the separation surface of the joined substrate or the separated substrate, which is to be subjected to the step of etching, is annealed at a temperature of 1000°C or higher in a hydrogen atmosphere.
[8]: The method for producing a semiconductor substrate according to any of the above [1] to [7], wherein
   in the step of etching, the separation surface of the joined substrate is plasma-etched, and after the step of etching, the step of performing epitaxial growth is performed on the separation surface etched of the joined substrate.
[9]: A semiconductor substrate comprising:
   a support substrate; and
   a 4H-SiC layer bonded onto a surface of the support substrate, wherein
   the support substrate is composed of SiC, and
   the 4H-SiC layer is bonded to the support substrate via a silicon thin film, and has a surface that is subjected to etching treatment.
[10]: A semiconductor device comprising the semiconductor substrate according to the above [9].

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for producing a semiconductor substrate, the method comprising the steps of:
implanting an ion of at least one of silicon, carbon, or oxygen into a surface of a 4H-SiC substrate, to form, within the 4H-SiC substrate, an amorphous layer composed of amorphized silicon and carbon;
bonding the surface of the 4H-SiC substrate and a bonding surface of another support substrate via a thin film formed on at least one of the surface of the 4H-SiC substrate that is subjected to the step of implanting the ion or the bonding surface of the support substrate, to obtain a bonded substrate;
separating the 4H-SiC substrate at the amorphous layer from the bonded substrate, thereby dividing the bonded substrate into a joined substrate in which a surface layer of the 4H-SiC substrate is transferred as a 4H-SiC layer on the support substrate, and a separated substrate that is the 4H-SiC substrate after the surface layer has been separated;
etching a separation surface of at least one of the joined substrate or the separated substrate, both of which have been subjected to the step of separating, by plasma etching; and
performing epitaxial growth on at least one of the joined substrate or the separated substrate.

2. The method for producing a semiconductor substrate according to claim 1, wherein
in the step of separating, the 4H-SiC substrate is separated by irradiating the amorphous layer with light, applying impact thereto, or performing combined processes thereof.

3. The method for producing a semiconductor substrate according to claim 1, wherein
in the step of implanting the ion, the oxygen ion is implanted, and
in the step of separating, the 4H-SiC substrate is separated by irradiating the amorphous layer with light, applying impact thereto, performing heat treatment to generate a gas through a reaction between the implanted oxygen and carbon in the amorphous layer, or performing combined processes thereof.

4. The method for producing a semiconductor substrate according to claim 1, wherein
in the step of bonding, a silicon thin film is formed as the thin film, and bonding is performed via the silicon thin film.

5. The method for producing a semiconductor substrate according to claim 4, wherein
in the step of bonding, the silicon thin film is formed by a sputtering method using silicon as a target.

6. The method for producing a semiconductor substrate according to claim 1, wherein
in the step of etching, a mixed gas of a fluorocarbon gas and oxygen is used as a raw material gas.

7. The method for producing a semiconductor substrate according to claim 1, wherein
after the step of separating and before the step of etching, a step of annealing is performed in which the separation surface of the joined substrate or the separated substrate, which is to be subjected to the step of etching, is annealed at a temperature of 1000°C or higher in a hydrogen atmosphere.

8. The method for producing a semiconductor substrate according to any one of claims 1 to 7, wherein
in the step of etching, the separation surface of the joined substrate is plasma-etched, and after the step of etching, the step of performing epitaxial growth is performed on the separation surface etched of the joined substrate.

9. A semiconductor substrate comprising:
a support substrate; and
a 4H-SiC layer bonded onto a surface of the support substrate, wherein
the support substrate is composed of SiC, and
the 4H-SiC layer is bonded to the support substrate via a silicon thin film, and has a surface that is subjected to etching treatment.

10. A semiconductor device comprising the semiconductor substrate according to claim 9.
